# EUROPÄISCHE PATENTSCHRIFT

(11) **EP 1 994 204 B1**
(45) Veröffentlichungstag und Bekanntmachung des Hinweises auf die Patenterteilung: **27.04.2011**
(21) Anmeldenummer: 07710509.6
(22) Anmeldetag: 12.03.2007
(51) Int. Cl.: C23C 30/00

(54) **WERKSTOFFVERBUND MIT PERIODISCH VERÄNDERTER MIKROSTRUKTUR**
MATERIAL COMPOSITE WITH PERIODICALLY CHANGED MICROSTRUCTURE
MATÉRIAU COMPOSITE À MICROSTRUCTURE CHANGEANT PÉRIODIQUEMENT

(30) Priorität: 14.03.2006 AT 19406 U
(43) Veröffentlichungstag der Anmeldung: 26.11.2008
(73) Patentinhaber: Ceratizit Austria Gesellschaft M.B.H., 6600 Reutte (AT)
(72) Erfinder: DANIEL, Claus, USA TN 37931, Knoxville (US); KATHREIN, Martin, A-6600 Reutte (AT); MÜCKLICH, Frank, 66773 Schwalbach (DE)
(86) Internationale Anmeldenummer: PCT/AT2007/000119
(87) Internationale Veröffentlichungsnummer: WO 2007/104065

(56) Entgegenhaltungen:
- EP-A- 1 473 102
- DANIEL C ET AL: "Periodical micro-nano-structuring of metallic surfaces by interfering laser beams" APPLIED SURFACE SCIENCE ELSEVIER NETHERLANDS, Bd. 208-209, 15. März 2003 (2003-03-15), Seiten 317-321, XP002435597 ISSN: 0169-4332
- VEITH M ET AL: "Periodical micro-structuring of hydride containing metastable aluminum oxide using laser interference metallurgy" ADVANCED ENGINEERING MATERIALS WILEY-VCH VERLAG GMBH GERMANY, Bd. 7, Nr. 1-2, Januar 2005 (2005-01), Seiten 27-30, XP002435598 ISSN: 1438-1656
- KAMMERMEIER D ET AL: "DAS WERKZEUG <OBERFLAECHLICH> BETRACHTET" WERKSTATT UND BETRIEB, CARL HANSER VERLAG, MUNCHEN, DE, Bd. 136, Nr. 3, März 2003 (2003-03), Seiten 38-40, XP001145168 ISSN: 0043-2792

## Beschreibung

Die Erfindung betrifft einen Werkstoffverbund, der einen Grundkörper aus einem verschleißbeständigen Werkstoff und eine Hartstoffschicht umfasst.

Zu der Gruppe der verschleißbeständigen Werkstoffe zählen Hartmetalle, Cermet-Werkstoffe, Hartstoffe und Werkzeugstähle, um die wichtigsten Vertreter zu nennen.

Unter Hartmetall versteht man dabei einen Verbundwerkstoff, der aus einer karbidischen Hartstoffphase und einem metallischen Binder, bevorzugt Kobalt, aufgebaut ist. Die Werkstoffgruppe der Cermet-Werkstoffe umfasst alle Werkstoffe, die aus einer oder mehreren keramischen Phasen und aus einer oder mehreren metallischen Phasen aufgebaut sind. Unter Hartstoffen werden alle Stoffe mit einer Härte von > 1.000 HV zusammengefasst. Dies sind insbesondere Verbindungen der Elemente der IVa bis VIa Gruppen des Periodensystems mit den Elementen Kohlenstoff, Stickstoff, Bor und Silizium. Jedoch auch Diamant, kubisches Bornitrid, Siliziumkarbid, Sialone, Aluminiumoxid, Aluminiumnitrid und Siliziumnitrid, um die wichtigsten zu nennen, fallen in diese Werkstoffgruppe. Werkzeugstähle sind nach DIN 17300 Stähle, die durch ihre Anwendung in Werkzeugen definiert sind.

Um die Verschleißfähigkeit zu erhöhen, werden speziell auf Hartmetallen, Cermets und Werkzeugstählen hoch verschleißfeste Hartstoffschichten auf der Basis von Karbiden, Nitriden, Boriden, Siliziden und Oxiden aufgebracht. Diese Schichten weisen Härtewerte auf, die üblicherweise im Bereich von 1.500 HV bis über 4.000 HV liegen.

Beschichtungen können beispielsweise mittels Physical Vapour Deposition (PVD) oder Chemical Vapour Deposition (CVD) Verfahren aufgetragen werden. Es existieren viele Verfahrensvarianten für die Schichtabscheidung sowohl beim PVD - als auch beim CVD-Verfahren. Beispielsweise werden chemische Aufdampfverfahren auch plasmaunterstützt (plasma assisted) durchgeführt, mit so genannten PA-CVD-Verfahren. Einlagige Hartstoffschichten genügen den gestiegenen Anforderungen vielfach nicht mehr. Es werden daher vielfach mehrlagige Beschichtungen eingesetzt, wobei dies von weniglagigen Beschichtungsarchitekturen bis hin zu Vielschichtsystemen reicht. Des Weiteren geht die Entwicklung von Ein- / Zweikomponentenschichten hin zu Mehrkomponentenbeschichtungen.

So finden ternäre Schichtsysteme, wie beispielsweise (Ti,Al)N, (Al,Cr)N oder quaternäre Schichtsysteme, wie beispielsweise (Ti,Al,V)N, (Ti,Al,Cr)N oder (Ti,Al,Si)N Verwendung. Durch dieses Zulegieren von weiteren Komponenten ist es möglich, die Härte von Schichtsystemen zu erhöhen. Damit verbunden ist jedoch im Allgemeinen eine Reduzierung der Bruchzähigkeit.

Weitere Schwerpunkte sind die Entwicklung von Nano-Kompositstrukturen, von reibungsvermindernden Schichten, z.B. auf der Basis von MoS₂, CrN, VN und von tribologisch aktiven Schichten, zum Beispiel auf der Basis des diamantähnlichen amorphen Kohlenstoffs.

Im Rahmen der Entwicklung der gegenständlichen Erfindung wurde nun versucht, die Struktur der Schicht oder der Schichtsysteme durch eine thermische Nachbehandlung zu modifizieren. Diese thermische Nachbehandlung wurde durch ein Glühen in einem Ofen durchgeführt. Um jedoch die Gefüge- und Mikrostruktur der keramischen Schicht zu ändern, sind Temperaturen von über 600°C notwendig. Diese thermische Nachbehandlung führte bei einigen Substratwerkstoffen zu einer unzulässigen Verschlechterung der Eigenschaften und Beeinträchtigungen der Schichthaftung. Zudem haben die Versuche gezeigt, dass durch die thermische Behandlung des gesamten Schichtvolumens im Allgemeinen nicht sowohl Härte und Duktilität verbessert werden, was eine Voraussetzung für ein optimiertes Verschleißverhalten der Schicht / des Schichtsystems ist.

Es ist daher die Aufgabe der gegenständlichen Erfindung eine thermische Nachbehandlung einer Hartstoffschicht bereit zu stellen, die zu einer Verbesserung der Verschleißbeständigkeit der Schicht führt, ohne dass dadurch jedoch die mechanischen Eigenschaften des Substratwerkstoffes sowie die Adhäsion der Schicht auf dem Substratwerkstoff negativ beeinflusst werden.

Die Aufgabe wird durch die unabhängigen Ansprüch 1 und 10 gelöst. Bevorzugte Ausführungsarten sind in den Unteransprüchen angegeben.

Die Hartstoffschicht wird dabei durch die Einwirkung eines Laserstrahles derart modifiziert, dass in periodischer Abfolge Bereiche mit veränderter Mikrostruktur entstehen. Diese Bereiche mit veränderter Mikrostruktur können entstehen indem:
■ metastabile Phasen sich in stabilere / stabile Phasen oder Phasenbestandteile umwandeln,
■ atomare Umlagerungen erfolgen,
■ Ausscheidung von neuen Phasen stattfinden;
■ sich die Korngröße oder Kornform ändert oder
■ Änderungen in der Struktur oder Textur stattfinden.

Die Verwendung von Laserstrahlen in Verbindung mit Schichten ist vielfach vorbeschrieben. So beschreibt die US 6,146,714 eine Methode zur gepulsten Laserabscheidung von beispielsweise keramischen Schichten. Zeitgleich mit dem Abscheideprozess wird eine Wärmebehandlung mit einem Laserstrahl durchgeführt, um eine rasche Aufheizung und Abkühlung der einzelnen Schichtlagen zu erzielen. So können amorphe, kolumnare oder polykristalline Strukturen eingestellt werden.

Die EP 0 819 782 beschreibt einen Prozess zur Herstellung einer Schicht durch Laser-Ablation, wobei die abgeschiedene Schicht durch Einwirkung eines Laserstrahls aufgeschmolzen oder rekristallisiert wird.

Die WO 2004/097064 offenbart die Bestrahlung einer Schicht während kurzzeitiger Unterbrechungen des Beschichtungsprozesses oder während des Schichtbildungsprozesses mit einem gepulsten Laserstrahl als Temperpuls oder mit mehreren gepulsten Laserstrahlen verschiedener Wellenlänge und Pulsdauer mit jeweils vorgegebener Energiefluenz und Pulswiederholfrequenz. Dabei handelt es sich bevorzugt um solche Schichten, die durch Ablagerung von wenigstens einem vorzugsweise gepulsten Teilchenstrom auf einem Substrat im Vakuum gebildet werden. Bei der Beschichtung größerer Substrate erfolgt die Bestrahlung von lateralen Bereichen der Schicht, um die erforderliche Energiefluenz zu erreichen.

Diese Dokumente beschreiben die lägenweise Modifikation von Schichten während des Beschichtungsprozesses. Die Schrift EP-A-1473 102 offenbart Schneidwerkzeuge mit einer Hortstoffschicht, die nach einer Laserbehandlung eine Mikrotopographie aufweisen. Die Modifikation der Schicht durch eine periodische Veränderung der Mikrostruktur in zumindest einer zur Schichtoberfläche parallelen Richtung ist nicht beschrieben.

Diese periodische Abfolge von Bereiche mit veränderter Mikrostruktur mit Bereichen mit unbehandelter Mikrostruktur, führt zu einer Veränderung der lokalen mechanischen Eigenschaften. Damit entsteht ein mikrostruktureller Oberflächenkomposit, welcher ein signifikant verbessertes Verschleißverhalten aufweist. Wesentlich dabei ist, dass sich Bereiche, die unter der Einwirkung eines Laserstrahls eine modifizierte Mikrostruktur ausgebildet haben, mit unbehandelten Bereichen abwechseln.

Unter Periodizität ist dabei grundsätzlich zu verstehen, dass sich Bereiche mit veränderter Mikrostruktur mit nicht modifizierten Bereichen abwechseln. In bevorzugter Weise sind die Abstände zwischen den einzelnen Bereichen konstant oder folgen einer bestimmten Gesetzesmäßigkeit. Beispielhaft ist dies nachfolgend ausgeführt, wobei A, B, C,... die Abstände zwischen den Bereichen mit modifizierter Mikrostruktur bezeichnen:
■ A, A, A, A, A, A, A, A, A, A, A, A,...
■ A, B, A, B, A, B, A, B, A, B, A, B, A ...
■ A, B, C, A, B, C, A, B, C, A, B, C ...
■ A, B, C, A, B, A, B, C, A, B, A, B, C, A, B ...
■ u.s.w.

Auf Grund beispielsweise der Oberflächenrauhigkeit können die einzelnen Abstände dabei leicht variieren.

Die in periodischer Abfolge auftretenden Bereiche mit modifizierter Mikrostruktur sind bevorzugt punktförmig, linienförmig oder netzförmig ausgebildet. Auch alle Kombinationen der zuvor angeführten Möglichkeiten auch in Kombination mit weiteren führen zur erfindungsgemäßen Verbesserung des Verschleißverhaltens. Die periodisch angeordneten, punktförmigen Bereiche weisen dabei in vorteilhafter Weise einen Durchmesser von 1 bis 10 µm und eine Tiefe von zumindest 50 nm bis 0,8 x Schichtdicke auf. Bei Verwendung von linienförmigen Bereichen, die wiederum periodisch auftreten, ist eine Länge von 5 µm bis 10 mm, eine Breite von 1µm bis 10 µm und eine Tiefe von 50 nm bis maximal 0,8 x Schichtdicke vorteilhaft. Sind die Bereiche mit veränderter Mikrostruktur netzförmig angeordnet, so hat sich eine Maschenweite von 3 bis 10 µm und eine Tiefe von 50 nm bis 0,8 x Schichtdicke als vorteilhaft erwiesen.

Für den Grundkörper finden die üblichen verschleißbeständigen Werkstoffe, insbesondere solche mit einer Härte > 500 HV Verwendung. Im Besonderen eignen sich dafür Hartmetall und Cermet-Werkstoffe.

Als Hartstoffschichten eigenen sich grundsätzlich alle keramischen Schichten, bei denen unter Einwirkung von Wärme während des Aufheiz- oder Abkühlvorganges mikrostrukturellen Veränderungen stattfinden. Im Besonderen sind hier karbidische, nitridische und karbonitridische Schichten zu nennen und hier wiederum insbesondere die Karbide, Nitride und Karbonitride der Metalle Titan, Zirkon, Hafnium, Chrom, Molybdän, Wolfram, Vanadium, Niob, Tantal und Aluminium sowie Mischungen davon.

Um die Bereiche mit veränderter Mikrostruktur, die sich in periodischer Abfolge wiederholen, herzustellen, wird die Oberfläche in bevorzugter Weise mittels des Laser-Interferenzverfahrens behandelt. Die an der Oberfläche mittels eines Lasers bereitgestellte elektromagnetische Strahlung wird zunächst nicht thermisch in oberflächennahen Bereichen absorbiert, vorausgesetzt die zur Verfügung gestellte Laserstrahlung weist eine Kreisfrequenz oberhalb der werkstoffspezifischen Plasmafrequenz auf. Diese nicht-thermisch absorbierte Energie wird bei einem Kurzpulslaser (ns-Puls) durch die Elektron-Gitter-Wechselwirkung im so genannten fotothermischen Mechanismus thermalisiert. Somit entspricht diese Behandlung primär einer extrem schnellen Aufheizung des Materials im Bereich von 20 Nanosekunden auf über 1.500°K und einer anschließenden Abschreckung im Zeitregime von 100 Nanosekunden auf Raumtemperatur.

Werden zwei oder mehrere kohärente Teilstrahlen über der Probe zur Deckung gebracht, bildet sich eine stehende Lichtwelle aus und die Wärmebehandlung geschieht nicht mehr an einem Fokuspunkt, sondern parallel periodisch über die gesamte bestrahlte Fläche. Es können Linien-, Netz- und Punktmuster erzeugt werden. Durch die Variation der Winkel zwischen den Strahlen können die Abstände und Breiten der Linien und Punkte variiert werden. Durch diese in periodischen Abständen erfolgende Wärmebehandlung können sowohl die Mikrostruktur, die Eigenspannungen und auch die Topografie der Hartstoffschicht beeinflusst werden. Im Falle der mikrostrukturellen Beeinflussung sind im Besonderen lokale Phasenbildungen, Änderungen der Korngröße und der Textur und Ausscheidungen zu nennen. Es kann periodisch zu kurzzeitigen, mikroskopischen Aufschmelzungen der oberflächennahen Schichtbereiche kommen, was zudem einen prinzipiellen Zugang zu allen bekannten metallurgischen Prozessen ermöglicht. Dieser Aufschmelzvorgang kann auch zu einer topografischen Veränderung der Oberfläche der Hartstoffschicht führen. Auch diese Veränderung der Topografie ist periodisch. Mittels PVD- und CVD-Verfahren abgeschiedene Schichten weisen üblicherweise eine kolumnare Struktur auf. Durch die periodische Einwirkung des Laserstrahls und die auftretenden, sehr hohen Abkühlgeschwindigkeiten kommt es zu einer Ausbildung eines ultrafeinkörnigen globularen Gefüges mit Korngrößen im Bereich von 2 bis 50 nm.

Die Textur kann sich insofern verändern, dass zu den stark orientierten Vorzugsrichtungen in kolumnaren Bereichen weitere Orientierungen hinzukommen. Phasen können sich sowohl in Art und Menge verändern. Die Veränderung der Mikrostruktur kann auch zu einer Änderung des Eigenspannungszustandes der Schicht führen. So konnte festgestellt werden, dass Werkstoffverbunde mit in periodischer Abfolge veränderter Mikrostruktur Druckeigenspannungen aufweisen, was sich günstig in Hinblick auf die Risseinleitungseigenschaften der Hartstoffschicht auswirkt. Die periodische Veränderung der Mikrostruktur in den oberflächennahen Bereichen der Hartstoffschicht ermöglicht die Einstellung eines periodischen Komposit-Werkstoffes mit präziser Fernordnung. Die mikroskopisch mechanischen Eigenschaften werden signifikant beeinflusst, wodurch es zu einer signifikanten Verbesserung des makroskopischen Verschleißverhaltens kommt.

Bei der erfindungsgemäßen Einwirkung des Laserstrahles tritt im Allgemeinen kein oder kein nennenswerter Werkstoffabtrag auf. Die Laserbehandlung kann lokal in auf Verschleiß beanspruchten Oberflächenbereichen begrenzt bleiben oder auf großen Oberflächenbereichen erfolgen. Die Oberfläche muss dabei nicht eben vorliegen. So ist es möglich, auch gekrümmte Oberflächenbereiche, wie diese beispielsweise bei Spanleitstufen von Wendeschneidplatten, Schneidkanten oder Bolzen und Kugeln vorliegen, erfindungsgemäß zu behandeln. Die Eindringtiefe der Strahlung bzw. des Wechselwirkungsbereiches ist in Abhängigkeit der Strahlungsenergie, der Strahlungsführung und des Werkstoffsystems variabel und kann bis in den µm-Bereich hineinreichen.

Bekannte Multikomponenten-Schichtsysteme für spezifische tribologische Anwendungsfälle können durch die Erzeugung von periodisch angeordneten Bereichen mit veränderter Mikrostruktur zusätzlich im Hinblick auf ihr Verschleißverhalten verbessert werden. Dies gilt ebenfalls für Multifunktionswerkzeuge, welche unterschiedlichen tribotogischen Anforderungen während des Einsatzes ausgesetzt sind.

Im Folgenden ist die Erfindung durch Beispiele näher beschrieben.

### Beispiele

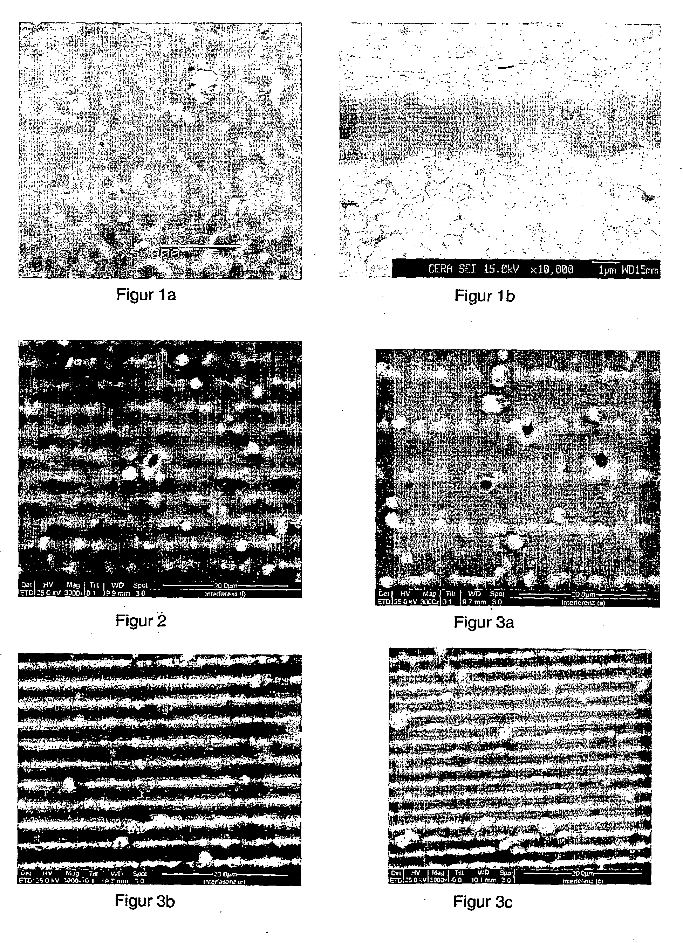

Figur 1a zeigt eine REM-Aufnahme der Topografie einer Hartstoffschicht im unbehandelten Zustand (Stand der Technik).
Figur 1b zeigt eine REM-Aufnahme des Bruchbildes einer Hartstoffschicht im unbehandelten Zustand (Stand der Technik).
Figur 2 zeigt eine REM-Aufnahme der Topografie einer Hartstoffschicht einer in punktförmigen / hundeknochenartigen Bereichen veränderten Mikrostruktur.
Figur 3a, b, c zeigen REM-Aufnahmen der Topografie von in linienförmigen Bereichen veränderter Mikrostruktur mit unterschiedlichen Linienbreiten und Linienabständen.

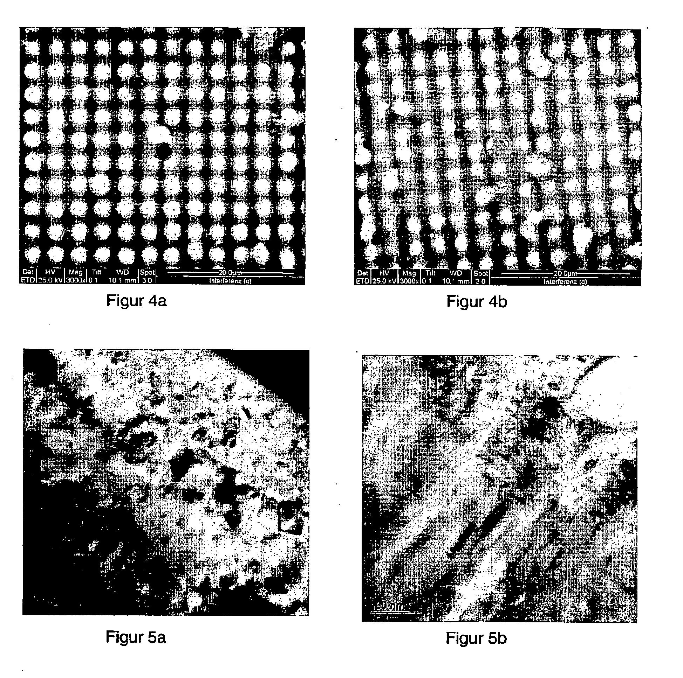

Figur 4a, b zeigen REM-Aufnahmen der Topografie einer in netzförmigen Bereichen veränderten Mikrostruktur.
Figur 5a, b zeigen TEM-Detailaufnahmen, wobei a) ein globulares, ultrafeinkörniges Gefüge in einem Bereich mit modifizierter Mikrostruktur (unter einem Laserinterferenzmaximum), und b) ein kolumnares Gefüge an einer nicht modifizierten Stelle darstellt.

Eine Ti-Al-V-N/Ti-Al-N Viellagenbeschichtung wurde mittels physikalischer Gasphasenabscheidung auf einem WC/TiC-Co-Hartmetallsubstrat mit einem Kobaltgehalt von 11 Gew.% und einem Titankarbidgehalt von 4 Gew.% aufgebracht. Röntgendiffraktometrisch zeigte die Schicht ein kubisch flächenzentriertes Titanaluminiumnitrid (fcc-TiAIN) als Hauptbestandteil. Weiters wies die Schicht eine kolumnare Überstruktur auf, die sich senkrecht zur Substratoberfläche erstreckt. Die Schichtdicke betrug durchschnittlich 4 µm. Zur Herstellung der Bereiche mit örtlich in periodischer Abfolge veränderter Mikrostruktur wurde die dritte Harmonische eines Nd:YAG-Hochleistungslasers mit der Wellenlänge von 355 nm genutzt. Für den Versuch wurden an der Probenoberfläche 10 Pulse mit der jeweiligen Laserfluenz von 620 bis 650 mJ/cm² zur Verfügung gestellt. Die austretende Strahlung wurde mittels eines optischen Systems in zwei bzw. drei kohärente Teilstrahlen getrennt und über der Probe zur Interferenz gebracht. So wurden für die nachfolgenden Verschleißexperimente 9 Proben mit einer strukturierten Fläche von jeweils ca. 50 mm², wie in der folgenden Tabelle 1 aufgelistet, hergestellt.

Die Untersuchung der Mikrostruktur wurde im Transmissionselektronenmikroskop durchgeführt. Dafür wurde in einem fokussierten lonenstrahlmikroskop eine TEM-Folie senkrecht zu Strukturlinien herauspräpariert und gedünnt, um die periodisch mikroskopischen Effekte zu analysieren. Es konnte gezeigt werden, dass im Bereich der Laserdifferenzmaxima die Kornstruktur signifikant verändert wurde. Die Bereiche mit Lasereinwirkung, die ursprünglich eine kolumnare Struktur aufwiesen, wurden aufgeschmolzen und kristallisierten bei sehr hohen Abkühlgeschwindigkeiten in ultra feinkörnigem globularen Gefüge mit einer Korngröße von ca. 15 nm.

**Tabelle 1**

| **Probenkennzeichnung** | **Musterart** | **Periodischer Abstand gemessen in Richtung** | **Periodischer Abstand der Bereiche mit veränderter Mikrostruktur [µm]** | **Verschleißtiefe [µm]** | **Figur** |
|---|---|---|---|---|---|
| a | Linien | senkrecht zu Linie | 8,3 | 3,2 | Figur 3a |
| b | Linien | senkrecht zu Linie | 3,6 | 2,8 | Figur 3b |
| c | Linien | senkrecht zu Linie | 2,4 | 3,7 | Figur 3c |
| d | Punkt / hunde-knochenartig | senkrecht zur Zeile | 5,7 | 3,5 | Figur 2 |
| e | Punkte / hunde-knochen-artig | senkrecht zur Zeile | 5,7 | 3,7 | |
| f | Punkt | senkrecht zur Zeile | 3,5 | 2,2 | Figur 4a |
| g | Punkt | senkrecht zur Zeile | 3,5 | 1,8 | Figur 4b |
| h (Stand der Technik) | unbehandelt | | | 4,3 | Figur 1a,b |
| i (Stand der Technik) | unbehandelt | | | 4,3 | |

Die tribologischen Untersuchungen wurden mittels eines Pin-on-Disc-Versuches mit 3 mm Radius, einer Normalkraft von 5 N und einer Gesamtstrecke zwischen 200 und 300 m durchgeführt. Nach dem Versuch wurde die Topografie der Verschleißspur analysiert.

Tabelle 1 gibt die Tiefen der Verschleißspuren wieder und zeigt, dass die erfindungsgemäßen Proben eine deutlich geringere Verschleißtiefe aufweisen, als die Stand der Technik Proben.

## Patentansprüche

1. Werkstoffverbund umfassend einen Grundkörper aus Hartmetall, Cermet-Werkstoff, Hartstoff oder Werkzeugstahl und eine Hartstoffschicht, **dadurch gekennzeichnet,**
**dass** die Hartstoffschicht durch die Einwirkung eines Laserstrahles in periodischer Abfolge in zumindest einer Richtung parallel zur Schichtoberfläche Bereiche mit globularer Kornform und umgebende Bereiche mit kolumnarer Kornform aufweist.

2. Werkstoffverbund nach Anspruch 1, **dadurch gekennzeichnet, dass** die Bereiche mit globularer Kornform eine Korngröße von 2 bis 50 nm aufweisen.

3. Werkstoffverbund nach Anspruch 1 oder 2, **dadurch gekennzeichnet, dass** zumindest 10, bevorzugt zumindest 100 Bereiche mit einer, im Vergleich zu umgebenden Bereichen, sich unterscheidenden Mikrostruktur periodisch angeordnet sind.

4. Werkstoffverbund nach einem der Ansprüche 1 bis 3, **dadurch gekennzeichnet, dass** die Bereiche mit einer, im Vergleich zu umgebenden Bereichen, sich unterscheidenden Mikrostruktur punktförmig, linienförmig und/oder netzförmig ausgebildet sind.

5. Werkstoffverbund nach Anspruch 4, **dadurch gekennzeichnet, dass** die punktförmigen Bereiche einen Durchmesser von 1 bis 10 µm und eine Tiefe von 50 nm bis 0,8 x Schichtdicke aufweisen.

6. Werkstoffverbund nach Anspruch 4, **dadurch gekennzeichnet, dass** die linienförmigen Bereiche eine Länge von 5 µm bis 10 mm, eine Breite von 1 µm bis 10 µm und eine Tiefe von 50 nm bis 0,8 x Schichtdicke aufweisen.

7. Werkstoffverbund nach Anspruch 4, **dadurch gekennzeichnet, dass** die netzförmigen Bereiche eine Maschenweite von 3 µm bis 10 µm und eine Tiefe von 50 nm bis 0,8 x Schichtdicke aufweisen.

8. Werkstoffverbund nach einem der Ansprüche 1 bis 7, **dadurch gekennzeichnet, dass** die Hartstoffschicht aus einem Karbid, Nitrid, Karbonitrid, Oxid, Borid oder Silizid gebildet ist.

9. Werkstoffverbund nach Anspruch 8, **dadurch gekennzeichnet, dass** die Hartstoffschicht aus einem Karbid, Nitrid oder Karbonitrid der Metalle Ti, Zr, Hf, Cr, Mo, W, V, Nb, Ta, Algebildet ist.

10. Verfahren zur Herstellung eines Werkstoffverbunds nach einem der Ansprüche 1 bis 9, **dadurch gekennzeichnet, dass** der in periodischer Abfolge einwirkende Laserstrahl durch zwei oder mehrere kohärente Laserteilstrahlen erzeugt wird, die unter Ausbildung einer stehenden Welle zur Interferenz gebracht werden.

11. Verfahren zur Herstellung eines Werkstoffirerbunds nach Anspruch 10, **dadurch gekennzeichnet, dass** der Laserstrahl eine Kreisfrequenz oberhalb der werkstoffspezifischen Plasmafrequenz aufweist.

12. Verfahren zur Herstellung eines Werkstoffverbunds nach Anspruch 10 oder 11, **dadurch gekennzeichnet, dass** die Einwirkung des Laserstrahls lokal eine Aufheizrate von > 1 x 10⁹ °C/s erzeugt.

13. Verfahren zur Herstellung eines Werkstoffverbunds nach einem der Ansprüche 10 bis 12, **dadurch gekennzeichnet, dass** nach Einwirkung des Laserstrahls lokal eine Abkühlrate von > 1 x 10⁸ °C/s auftritt.

14. Verfahren zur Herstellung eines Werkstoffverbunds nach einem der Ansprüche 10 bis 13, **dadurch gekennzeichnet, dass** die Bereiche mit einer, im Vergleich zu umgebenden Bereichen, sich unterscheidenden Mikrostruktur durch die Einwirkung der dritten Harmonischen eines Nd:YAG Lasers mit der Wellenlänge von 355 nm erzeugt werden.

## Claims

1. Composite material comprising a base body of hard metal, cermet material, hard material or tool steel, and a hard-material layer,
**characterised in that**
the hard-material layer, as a result of the action of a laser beam, has regions having a globular particle shape and surrounding regions having a columnar particle shape in periodic sequence in at least one direction parallel to the layer surface.

2. Composite material according to claim 1, **characterised in that** the regions having a globular particle shape have a particle size of from 2 to 50 nm.

3. Composite material according to claim 1 or 2, **characterised in that** at least 10, preferably at least 100, regions having a different microstructure compared with surrounding regions are arranged periodically.

4. Composite material according to any one of claims 1 to 3, **characterised in that** the regions having a different microstructure compared with surrounding regions are in point, line and/or lattice form.

5. Composite material according to claim 4, **characterised in that** the regions in point form have a diameter of from 1 to 10 µm and a depth of from 50 nm to 0.8 x layer thickness.

6. Composite material according to claim 4, **characterised in that** the regions in line form have a length of from 5 µm to 10 mm, a width of from 1 µm to 10 µm and a depth of from 50 nm to 0.8 x layer thickness.

7. Composite material according to claim 4, **characterised in that** the regions in lattice form have a mesh size of from 3 µm to 10 µm and a depth of from 50 nm to 0.8 x layer thickness.

8. Composite material according to any one of claims 1 to 7, **characterised in that** the hard-material layer is formed of a carbide, nitride, carbonitride, oxide, boride or silicide.

9. Composite material according to claim 8, **characterised in that** the hard-material layer is formed of a carbide, nitride or carbonitride of the metals Ti, Zr, Hf, Cr, Mo, W, V, Nb, Ta, Al.

10. Process for the production of a composite material according to any one of claims 1 to 9, **characterised in that** the laser beam, which acts in periodic sequence, is produced by two or more coherent partial laser beams which are brought to interference with the formation of a standing wave.

11. Process for the production of a composite material according to claim 10, **characterised in that** the laser beam has an angular frequency above the material-specific plasma frequency.

12. Process for the production of a composite material according to claim 10 or 11, **characterised in that** the action of the laser beam produces locally a heating rate of > 1 x 10⁹ °C/s.

13. Process for the production of a composite material according to any one of claims 10 to 12, **characterised in that**, after the action of the laser beam, a cooling rate of > 1 x 10⁸ °C/s occurs locally.

14. Process for the production of a composite material according to any one of claims 10 to 13, **characterised in that** the regions having a different microstructure compared with surrounding regions are produced by the action of the third harmonic of a Nd:YAG laser having a wavelength of 355 nm.

## Revendications

1. Matériau composite comprenant un corps de base en métal dur, en matériau de type cermet, en matériau dur ou en acier à outils et une couche de matériau dur,
**caractérisé en ce que**,
par l'effet d'un rayon laser, la couche de matériau dur présente des zones à structure granuleuse globulaire et des zones à structure colonnaire qui les entourent, selon une séquence périodique dans au moins une direction parallèle à la surface de couche.

2. Matériau composite selon la revendication 1, **caractérisé en ce que** la granulométrie des zones à structure granuleuse globulaire est de 2 à 50 nm.

3. Matériau composite selon la revendication 1 ou 2, **caractérisé en ce que** au moins 10, de préférence au moins 100 zones dont la microstructure se différencie de celle des zones qui les entourent sont disposées de façon périodique.

4. Matériau composite selon l'une quelconque des revendications précédentes, **caractérisé en ce que** la forme des zones dont la microstructure se différencie des zones qui les entourent est ponctuelle, linéaire et/ou réticulaire.

5. Matériau composite selon la revendication 4, **caractérisé en ce que** le diamètre des zones ponctuelles est de 1 à 10 µm et leur profondeur est de 50 nm à 0,8 fois l'épaisseur de la couche.

6. Matériau composite selon la revendication 4, **caractérisé en ce que** la longueur des zones linéaires est de 5 µm à 10 mm, leur largeur est de 1 µm à 10 µm, et leur profondeur est de 50 nm à 0,8 fois l'épaisseur de la couche.

7. Matériau composite selon la revendication 4, **caractérisé en ce que** la largeur de mailles des zones
réticulaires est de 3 µm à 10 µm et leur profondeur est de 50 nm à 0,8 fois l'épaisseur de la couche..

8. Matériau composite selon l'une quelconque des revendications précédentes, **caractérisé en ce que** la couche de matériau dur consiste en un carbure, un nitrure, un carbonitrure, un oxyde, un borure ou un siliciure.

9. Matériau composite selon la revendication 8, **caractérisé en ce que** la couche de matériau dur consiste en un carbure, un nitrure ou un carbonitrure des métaux Ti, Zr, Hf, Cr, Mo, W, V, Nb, Ta, Al.

10. Procédé de fabrication d'un matériau composite selon l'une quelconque des revendications précédentes, **caractérisé en ce que** le rayon laser à effet séquentiel périodique est généré par deux rayons partiels laser cohérents ou davantage qui sont amenés en interférence en formant une onde stationnaire.

11. Procédé de fabrication d'un matériau composite selon la revendication 10, **caractérisé en ce que** la fréquence angulaire du rayon laser est supérieure à la fréquence de plasma spécifique du matériau.

12. Procédé de fabrication d'un matériau composite selon la revendication 10 ou 11, **caractérisé en ce que** l'effet du rayon laser génère localement une vitesse d'échauffement > 1 x 10⁹ °C/s.

13. Procédé de fabrication d'un matériau composite selon l'une quelconque des revendications 10 à 12, **caractérisé par** une vitesse locale de refroidissement > 1 x 10⁸°C/s après l'effet du rayon laser.

14. Procédé de fabrication d'un matériau composite selon l'une quelconque des revendications 10 à 13, **caractérisé en ce que** les zones dont la microstructure se différencie de celle des zones qui les entourent sont générées par l'effet du troisième harmonique d'un laser Nd:YAG d'une longueur d'onde de 355 nm.
